# EUROPEAN PATENT SPECIFICATION

(11) **EP 3 041 035 B1**
(45) Date of publication and mention of the grant of the patent: **03.10.2018**
(21) Application number: 14841257.0
(22) Date of filing: 27.08.2014
(51) Int. Cl.: H01L 41/318

(54) **METHOD FOR MANUFACTURING PNBZT THIN FILM**
VERFAHREN ZUR HERSTELLUNG EINER PNBZT-DÜNNSCHICHT
PROCÉDÉ DE FABRICATION DE FILM MINCE PNBZT

(30) Priority: 27.08.2013 JP 2013175100; 26.08.2014 JP 2014171180
(43) Date of publication of application: 06.07.2016
(73) Proprietor: Mitsubishi Materials Corporation, Chiyoda-ku Tokyo 100-8117 (JP)
(72) Inventor: DOI, Toshihiro, Naka-shi Ibaraki 311-0102 (JP); SAKURAI, Hideaki, Naka-shi Ibaraki 311-0102 (JP); SOYAMA, Nobuyuki, Naka-shi Ibaraki 311-0102 (JP)
(74) Representative: Gille Hrabal
(86) International application number: PCT/JP2014/072457
(87) International publication number: WO 2015/030064

(56) References cited:
- JP-A- 2000 036 571
- JP-A- 2002 343 791
- JP-A- 2004 152 922
- JP-A- 2004 152 922
- JP-A- 2005 100 660
- JP-A- 2005 272 294
- JP-A- 2009 054 618
- JP-A- 2012 256 851
- JP-A- 2012 519 378
- US-A1- 2006 083 933

## Description

### TECHNICAL FIELD

The present invention relates to a method for manufacturing a PNbZT thin film used in a thin-film piezoelectric device of a thin-film capacitor, or the like.

### BACKGROUND ART

It is known that piezoelectric characteristics are enhanced by adding Nb to a PZT thin film expressed by the composition formula Pb_{z}ZrₓTi₁₋ₓO₃ formed by a sol-gel method (for example, refer to NPL 1). In this paper, an effect of Nb doping on a (100)-textured PZT thin film grown on a PbTiO₃ seeding layer prepared by a chemical solution deposition (CSD) method was investigated. Specifically, an effect of Nb doping in the range of 0 at% to 4 at% on 1 µm thick (100)-textured Pb_{1.1}Zr_{0.52}Ti_{0.48}O₃ thin film was investigated. Texturing of (100) as high as 97% is obtained for all the films due to the incorporation of a thin Pb_{1.05}TiO₃ seeding layer having a thickness of several nanometers. Overall, the maximum polarization, remanent polarization, squareness, and coercivity of the PZT thin film decrease with the Nb doping level. The PZT thin film doped with 3% Nb shows the maximum effective piezoelectric coefficient -e_{31,f} of 12.9 C/cm², which is 5% to 15% higher than those of thin films with other doping levels.

### DOCUMENTS OF RELATED ART

### NON-PATENT LITERATURE

[NPL 1] Jian Zhong et al., "Effect of Nb Doping on Highly {100}-Textured PZT Films Grown on CSD-Prepared PbTiO3 Seed Layers", Integrated Ferroelectrics 130(2011)1-11.

### PATENT LITERATURE

[PL1] US2006/0083933

### DISCLOSURE OF INVENTION

### PROBLEMS TO BE SOLVED BY THE INVENTION

However, in the technique for enhancing the piezoelectric characteristics of the PZT thin film by the addition of Nb described in NPL 1 according to the related art, when the PZT thin film (PNbZT thin film) doped with Nb is formed by a wet type method, that is, a chemical solution deposition (CSD) method using a sol-gel solution, concentration gradients of Zr and Ti in a film thickness direction occur during each baking, and thus there is a problem in that the piezoelectric characteristics and the like of the PNbZT thin film are degraded. PL1 discloses a ferroelectric film formed by an oxide that is described by a general formula AB1-xNbxO3. An A element includes at least Pb, and a B element includes at least one of Zr, Ti, V, W, Hf and Ta. The ferroelectric film includes Nb within the range of: 0.05<=x<1. The ferroelectric film can be used for any of ferroelectric memories of 1T1C, 2T2C and simple matrix types.

An object of the present invention is to provide a method for manufacturing a PNbZT thin film, in which each composition in the film is substantially uniform and higher piezoelectric characteristics and dielectric characteristics can be obtained.

### MEANS TO SOLVE THE PROBLEMS

The inventors found that: when a coating film formed on a substrate using a sol-gel solution that satisfies the composition formula Pb_{z}NbₓZr_{y}Ti_{1-y}O₃ is calcined and the calcined film is baked, a Zr element is less likely to be crystallized compared to a Ti element, the Zr element and the Ti element are thus segregated; and the behavior of segregation regarding an Nb element is not discovered, there is still room for improvement in piezoelectric characteristics and the like, and the inventors accomplished the present invention.

A first aspect of the present invention is a method for manufacturing a PNbZT thin film including: a process of preparing a plurality of types of sol-gel solutions having different concentration ratios of zirconium and titanium (Zr/Ti) while satisfying the composition formula Pb_{z}NbₓZr_{y}Ti_{1-y}O₃ (0<x≤0.05, 0.40≤y≤0.60, and 1.05≤z≤1.25); a process of laminating at least two layers of calcined films, in which the concentration ratio Zr/Ti are decreased in a stepwise manner, on a substrate by selecting a predetermined sol-gel solution from among the plurality of types of sol-gel solutions so as to allow the concentration ratio Zr/Ti to be decreased in a stepwise manner, and repeating application of the sol-gel solutions onto the substrate and calcining the resultant at least two times; and a process of obtaining a single PNbZT thin film formed from lead niobate zirconium titanate-based complex perovskite by simultaneously baking a plurality of the calcined films, and furthermore, a composition variation of zirconium in a film thickness direction of the single PNbZT thin film after the baking is 5% or lower.

A second aspect of the present invention is an invention based on the first or second aspect, and furthermore, a thickness of the single PNbZT thin film is 250 nm to 400 nm.

A third aspect of the present invention is a method for manufacturing an electronic component of a thin-film condenser, a thin film capacitor, an IPD, a condenser for a DRAM memory, a multi-layer condenser, the gate insulator of a transistor, a non-volatile memory, a pyroelectric infrared detecting element, a piezoelectric element, an electro-optic element, a thin film actuator, a resonator, an ultrasonic motor, or an LC noise filter element, which has the PNbZT thin film according to the method described in any one of the first to third aspects.

### ADVANTAGEOUS EFFECTS OF INVENTION

In the method for manufacturing the PNbZT thin film according to the first aspect of the present invention, the at least two layers of calcined films, in which the concentration ratio Zr/Ti are decreased in a stepwise manner, are laminated on the substrate by selecting a predetermined sol-gel solution from among the plurality of types of sol-gel solutions so as to allow the concentration ratio Zr/Ti to be decreased in a stepwise manner, and repeating the application of the sol-gel solutions onto the substrate and calcining the resultant at least two times, and the single PNbZT thin film formed from lead niobate zirconium titanate-based complex perovskite is obtained by simultaneously baking the calcined films. Therefore, the composition distribution of each element in the film thickness direction in the PNbZT thin film is substantially uniform, and thus a PNbZT thin film having higher piezoelectric characteristics and dielectric characteristics can be obtained. In other words, in order to obtain desired piezoelectric characteristics and dielectric characteristics, a PNbZT thin film having a smaller film thickness can be used, and thus a reduction in the cost of an electronic component using the PNbZT thin film can be achieved. In addition, by using the PNbZT thin film having a small film thickness, the displacement of the film can be increased, and thus an actuator having higher characteristics can be manufactured using the PNbZT thin film.

In the method for manufacturing a PNbZT thin film according to the second aspect of the present invention, since the composition variation of zirconium in the film thickness direction in the single PNbZT thin film after the baking is as low as 5% or lower, each composition in the PNbZT thin film is substantially uniform, and thus the above-described effect is obtained.

### BRIEF DESCRIPTION OF THE DRAWINGS

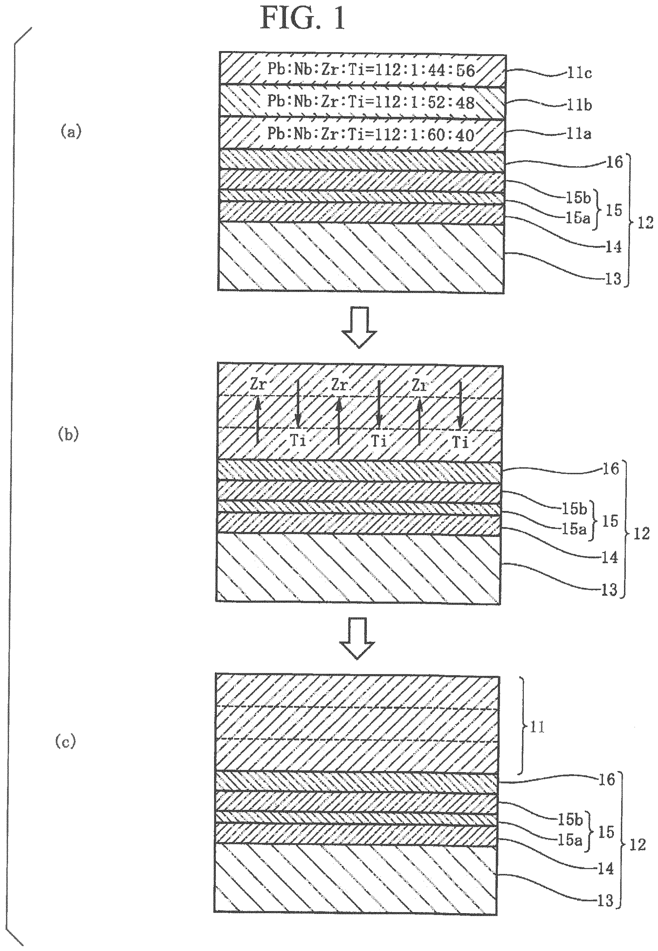

FIG. 1 is a schematic sectional view showing a process for manufacturing a PNbZT thin film of an embodiment of the present invention, in which the upper section of the figure is referred to as an upper section (a) of FIG. 1, the middle section of the figure is referred to as a middle section (b) of FIG. 1, and the lower section of the figure is referred to as a lower section (c) of FIG. 1.

### BEST MODE FOR CARRYING OUT THE INVENTION

Next, an embodiment for embodying the present invention will be described with reference to the drawings. A method for manufacturing a PNbZT thin film includes: a process of preparing a plurality of types of sol-gel solutions having different concentration ratio Zr/Ti of zirconium and titanium; a process of laminating at least two layers of calcined films, in which the concentration ratio Zr/Ti are decreased in a stepwise manner, on a substrate; and a process of obtaining a single PNbZT thin film by simultaneously baking a plurality of the calcined films. Specifically, first, the plurality of types of sol-gel solutions having different concentration ratio Zr/Ti of zirconium and titanium while satisfying the composition formula Pb_{z}NbₓZr_{y}Ti_{1-y}O₃ (0<x≤0.05, 0.40≤y≤0.60, and 1.05≤z≤1.25) are prepared. In the sol-gel solution, a PNbZT precursor as the raw material for forming a complex metal oxide having a perovskite structure in a thin film after the formation is contained to achieve desired metal atomic ratios, that is, metal atomic ratios in which x satisfies 0<x≤0.05, y satisfies 0.40≤y≤0.60, and z satisfies 1.05≤z≤1.25 when expressed as the composition formula. Here, the reason that x is limited to the range of 0<x≤0.05 is that, when x is 0, the permittivity of a thin-film condenser which uses the PNbZT thin film is not high and leakage current cannot be reduced, and when x exceeds 0.05, cracking easily occurs in the PNbZT thin film. In addition, the reason that y is limited to the range of 0.40≤y≤0.60 is that, when y is less than 0.40, a sufficient permittivity or a piezoelectric constant is not obtained, and when y exceeds 0.60, the crystallization temperature is increased and it becomes difficult to carry out baking. Furthermore, the reason that z is limited to the range of 1.05≤z≤1.25 is that, when z is less than 1.05, a pyrochlore phase is generated, and the piezoelectric characteristics are significantly deteriorated, and when z exceeds 1.25, Pb remains as lead oxide in the PNbZT thin film, which results in an increase in leakage current and the degradation of the reliability of the element.

As the sol-gel solutions having different concentration ratio Zr/Ti, for example, five types of sol-gel solutions having concentration ratio Zr/Ti of 60/40, 54/46, 52/48, 50/50, and 44/56 may be prepared, three types of sol-gel solutions having concentration ratio Zr/Ti of 60/40, 52/48, and 44/56 may be prepared, or two types of sol-gel solutions having concentration ratio Zr/Ti of 60/40, and 44/56 may be prepared.

Next, a predetermined sol-gel solution is selected from among the plurality of types of sol-gel solutions so as to allow the concentration ratio Zr/Ti to be decreased in a stepwise manner, and applying the sol-gel solution onto the substrate and calcining the resultant are repeated at least two times such that at least two layers of calcined films in which the concentration ratio Zr/Ti are decreased in a stepwise manner are laminated on the substrate. Here, as shown in the lower section (c) of FIG. 1, a substrate 12 includes a substrate body 13 made of Si, an SiO₂ film 14 provided on the substrate body 13, and a lower electrode 15 provided on the SiO₂ film 14. The lower electrode 15 is formed of a material that have conductivity caused by Pt, TiOₓ, Ir, Ru, or the like and does not react with a PNbZT thin film 11. For example, the lower electrode 15 may have a two-layer structure including a TiOₓ film 15a and a Pt film 15b in this order from the substrate body 13 side. Specific examples of the TiOₓ film 15a include a TiO₂ film. Furthermore, the SiO₂ film 14 is formed to enhance adhesion. In addition, in the substrate 12, it is preferable that a ferroelectric thin film formed of a complex perovskite film made of lead zirconate titanate (PZT), which does not contain Nb, be formed on the Pt film 15b of the lower electrode 15 as a crystallization acceleration layer 16 to a predetermined film thickness. As a composition material used for forming the crystallization acceleration layer 16, a PZT precursor as the raw material for forming a complex metal oxide having a perovskite structure is preferably contained in a proportion such that desired metal atomic ratios are achieved. Specifically, it is preferable that the PZT precursor be contained in a proportion that achieves metal atomic ratios in which A in the composition formula Pb_{A}Zr_{1-B}Ti_{B}O₃ satisfies 1.0≤A≤1.25, and B satisfies 0.4≤B≤0.6.

### (a) In Case of Laminating Two Layers of Calcined Films on Substrate

First, two types of sol-gel solutions having different concentration ratio Zr/Ti are prepared. Next, the sol-gel solution having a high concentration ratio Zr/Ti is selected and applied onto a substrate, and the resultant is thereafter calcined, thereby forming a first calcined film. Furthermore, the sol-gel solution having a low concentration ratio Zr/Ti is selected and applied onto the first calcined film, and the resultant is thereafter calcined, thereby forming a second calcined film.

### (b) In Case of Laminating Three Layers of Calcined Films on Substrate (Upper Section (a) of FIG. 1)

First, three types of sol-gel solutions having different concentration ratio Zr/Ti are prepared. Next, the sol-gel solution having the highest concentration ratio Zr/Ti is selected and applied onto the substrate 12, and the resultant is thereafter calcined, thereby forming a first calcined film 11a. Next, the sol-gel solution having the second highest concentration ratio Zr/Ti is selected and applied onto the first calcined film 11a, and the resultant is thereafter calcined, thereby forming a second calcined film 11b. Furthermore, the sol-gel solution having the lowest concentration ratio Zr/Ti is selected and applied onto the second calcined film 11b, and the resultant is thereafter calcined, thereby forming a third calcined film 11c.

### (c) In Case of Laminating Four or More Layers of Calcined Films on Substrate

First, four or more types of sol-gel solutions (the same number as that of calcined films) having different concentration ratio Zr/Ti are prepared. Next, the sol-gel solution having the highest concentration ratio Zr/Ti is selected and applied onto a substrate, and the resultant is thereafter calcined, thereby forming a first calcined film. Next, the sol-gel solution having the second highest concentration ratio Zr/Ti is selected and applied onto the first calcined film, and the resultant is thereafter calcined, thereby forming a second calcined film. Thereafter, a predetermined sol-gel solution is selected from among the plurality of types of sol-gel solutions so as to allow the concentration ratio Zr/Ti to be decreased in a stepwise manner, and applying the sol-gel solutions on the second calcined film and calcining the resultant are repeated at least two times, thereby laminating, on the substrate, four or more layers of calcined films in which the concentration ratio Zr/Ti are decreased in a stepwise manner.

In addition, a method of applying the sol-gel solutions is not particularly limited, and may employ spin coating, dip coating, a liquid source misted chemical deposition (LSMCD) method, an electrostatic spray method, or the like. In addition, calcination is performed using a hot plate, a rapid thermal annealing (RTA) process, or the like under predetermined conditions. It is preferable that the calcination be performed in the air, an oxidizing atmosphere, or a water vapor-containing atmosphere. In addition, in order to sufficiently remove a solvent or the like and further enhance a cracking suppression effect, or in order to accelerate the densification of a film structure, the calcination may also be performed through two-stage calcination in which a heating holding temperature is changed. In a case of performing calcination in a single stage, it is preferable that holding be performed at a temperature of 275°C to 325°C for 3 minutes to 10 minutes. In a case of performing calcination in two stages, it is preferable that holding be performed at a temperature of 250°C to 300°C for 3 minutes to 10 minutes in the first stage, and holding is performed at a temperature of 400°C to 500°C for 3 minutes to 10 minutes in the second stage. Before the calcination, in order to remove particularly a low-boiling-point solvent and adsorbed water molecules, low-temperature heating of holding at a temperature of 70°C to 90°C for 0.5 minutes to 5 minutes using a hot plate or the like may be performed.

Furthermore, a single PNbZT thin film which is formed from lead niobate zirconium titanate-based complex perovskite is obtained by simultaneously baking the plurality of calcined films. The baking is a process for baking the plurality of calcined films at a temperature of the crystallization temperature or higher so as to make the films be crystallized. The baking atmosphere in the crystallization process is preferably a gas atmosphere of O₂, N₂, Ar, N₂O, or H₂, or a mixed gas atmosphere thereof. In addition, the baking is performed by holding at 600°C to 700°C for 0.5 minutes to 5 minutes, and the temperature rising rate is preferably 10 °C/s to 50 °C/s in a case of performing the baking through the rapid thermal annealing (RTA) process.

The film thickness of the single PNbZT thin film, that is, the film thickness of the PNbZT thin film formed by a single baking process is preferably 250 nm or more and 400 nm or less, and more preferably 270 nm or more and 380 nm or less. In addition, a composition variation of zirconium in the film thickness direction of the PNbZT thin film is 5% or lower, and preferably 3% or lower. Here, the reason that the film thickness of the PNbZT thin film formed in the single baking process is limited to the range of 250 nm or more and 400 nm or less is that, when the film thickness is less than 250 nm, the productivity is reduced, and when the film thickness exceeds 400 nm, cracking easily occurs in the PNbZT thin film during the formation. In addition, the reason that the composition variation of zirconium in the film thickness direction of the PNbZT thin film is limited to 5% or lower is that, when the composition variation exceeds 5%, the piezoelectric characteristics are degraded. The film thickness of the PNbZT thin film formed by a plurality of baking processes is preferably 1000 nm to 5000 nm, and more preferably 2000 nm to 3000 nm. Here, the reason that the film thickness of the PNbZT thin film formed by the plurality of baking processes is limited to 1000 nm to 5000 nm is that, when the film thickness is less than 1000 nm, a sufficient displacement amount for use in an actuator is not obtained, and when the film thickness exceeds 5000 nm, cracking easily occurs, and it is difficult to obtain a good quality film.

When the baking is performed in the state in which the plurality of layers of calcined films are laminated on the substrate so as to allow the concentration ratio Zr/Ti to be decreased in a stepwise manner, a Zr element is less likely to be crystallized compared to a Ti element in the plurality of layers of calcined films. Therefore, Zr which is the element that is less likely to be crystalized moves in a direction away from the substrate, while Ti which is the element that is easily crystalized moves in a direction approaching the substrate (middle section (b) of FIG. 1). Accordingly, the Zr concentration is decreased while the Ti concentration is increased in the calcined film that is closest to the substrate, and the Zr concentration is gradually increased while the Ti concentration is gradually decreased in the calcined films as it becomes distant from the substrate. Therefore, Zr and Ti in the single PNbZT thin film 11 that is obtained by the baking become substantially uniform in the film thickness direction. In addition, since Nb is not segregated during baking, Nb becomes substantially uniform in the film thickness direction in the single PNbZT thin film 11 that is obtained by the baking. As a result, the composition in the single PNbZT thin film 11 obtained by the baking becomes substantially uniform, not only in a plane parallel to the laminated surface, but also in a plane perpendicular to the laminated surface, that is, the film thickness direction (lower section (c) of FIG. 1), thereby obtaining the PNbZT thin film 11 having higher piezoelectric characteristics and dielectric characteristics. In other words, in order to obtain desired piezoelectric characteristics and dielectric characteristics, a PNbZT thin film having a smaller film thickness can be used, and a reduction in the cost of an electronic component which uses the PNbZT thin film can be achieved. Specifically, by using a PNbZT thin film having a small film thickness, the displacement of the film can be increased. Therefore, an actuator having higher characteristics can be manufactured using the PNbZT thin film.

The PNbZT precursor in the sol-gel solution is appropriately a compound in which an organic group is bonded to each of the metal elements Pb, Zr, Ti, Nb, and the like through an oxygen atom or a nitrogen atom. Examples thereof include one type or two or more types selected from the group consisting of metal alkoxides, metal-diol complexes, metal-triol complexes, metal carboxylates, metal-β-diketonate complexes, metal-β-diketoester complexes, metal-β-iminoketo complexes, and metal-amino complexes. Particularly appropriate compounds include metal alkoxides as well as partial hydrolysates and organic acid salts thereof.

Specifically, examples of a Pb compound include lead acetate [Pb(OAc)₂] and lead diisopropoxide [Pb(OiPr)₂]. Examples of a Ti compound include alkoxides such as titanium (iv) tetraethoxide [Ti(OEt)₄], titanium (iv) tetraisopropoxide [Ti(OiPr)₄], titanium (iv) tetra n-butoxide [Ti(OnBu)₄], titanium (iv) tetraisobutoxide [Ti(OiBu)₄], titanium (iv) tetra t-butoxide [Ti(OtBu)₄], and titanium dimethoxy diisopropoxide [Ti(OMe)₂(OiPr)₂]. As a Zr compound, the same alkoxides as those of the Ti compound are preferable. Metal alkoxides may be used without any change, and partial hydrolysates thereof may also be used in order to accelerate decomposition. Examples of an Nb compound include niobium pentaethoxide and niobium 2-ethylhexanoate.

In order to prepare the sol-gel solutions, the raw materials are dissolved in an appropriate solvent, and are prepared to have an appropriate concentration for application. As the solvent, carboxylic acids, alcohols (for example, ethanol, 1-butanol, and polyols excluding diols), esters, ketones (for example, acetone or methyl ethyl ketone), ethers (for example, dimethylether or diethylether), cycloalkanes (for example, cyclohexane or cyclohexanol), aromatic compounds (for example, benzene, toluene, or xylene), tetrahydrofurans, or a mixed solvent of at least two types thereof, may be used. From the viewpoint of the vaporization rate and solubility, 1-butanol, ethanol, or propylene glycol is particularly preferable.

Specific examples of the carboxylic acids include n-butyric acid, α-methylbutyric acid, i-valeric acid, 2-ethylbutyric acid, 2,2-dimethylbutyric acid, 3,3-dimethylbutyric acid, 2,3-dimethylbutyric acid, 3-methylpentanoic acid, 4-methylpentanoic acid, 2-ethylpentanoic acid, 3-ethylpentanoic acid, 2,2-dimethylpentanoic acid, 3,3-dimethylpentanoic acid, 2,3-dimethylpentanoic acid, 2-ethylhexanoic acid, and 3-ethylhexanoic acid.

In addition, as specific examples of the esters, ethyl acetate, propyl acetate, n-butyl acetate, sec-butyl acetate, tert-butyl acetate, isobutyl acetate, n-amyl acetate, sec-amyl acetate, tert-amyl acetate, and isoamyl acetate are preferably used, and examples of alcohols include 1-propanol, 2-propanol, 1-butanol, 2-butanol, isobutyl alcohol, 1-pentanol, 2-pentanol, 2-methyl-2-pentanol, and 2-methoxyethanol.

The ratio of the PNbZT precursor to 100 mass% of the sol-gel solution is preferably in a range of 5 mass% to 30 mass% in terms of oxide amount. When the ratio is less than the lower limit, it is difficult to form a film having a sufficient film thickness, and there may be cases where productivity is degraded. When the ratio exceeds the upper limit, the viscosity thereof is increased, and there may be cases where it becomes difficult to perform uniform application. Specifically, the ratio of the PNbZT precursor is preferably 10 mass% to 25 mass% in terms of oxide amount. In addition, a ratio in terms of oxide amount means the ratio of a metal oxide to 100 mass% of the sol-gel solution when it is assumed that all metal elements included in the sol-gel solution become oxides.

If necessary, a stabilizing agent may be added to the sol-gel solution in an amount of about 0.2 to 3 in terms of (number of molecules of stabilizing agent)/(number of metal atoms), the stabilizing agent including β-diketones (for example, acetyl acetone, heptafluoro butanoil pivaloyl methane, dipivaloyl methane, trifluoroacetylacetone, and benzoylacetone), β-ketonic acids (for example, acetoacetic acid, propionyl acetic acid, and benzoyl acetic acid), β-keto esters (for example, lower alkyl esters such as methyl, propyl, or butyl of the above-mentioned ketonic acids), oxyacids (for example, lactic acid, glycol acid, α-oxybutyric acid, and salicylic acid), lower alkyl esters of the above-mentioned oxyacids, oxyketones (for example, diacetone alcohol, and acetoin), diols, triols, higher carboxylic acids, alkanolamines (for example, diethanolamine, triethanolamine, and monoethanolamine), and polyamines. Specifically, acetyl acetone of β-diketones is preferable as the stabilizing agent.

In order to prepare the sol-gel solution, first, the PNbZT precursors such as the above-mentioned Pb compound and the like are prepared, and are weighed so that the desired metal atomic ratios are achieved. The weighed PNbZT precursor and the solvent are injected into a reaction container, are preferably circulated while being held at a temperature of 130°C to 170°C in a nitrogen atmosphere for 0.5 hours to 5 hours, thereby preparing a synthesized liquid. After the circulation, desolvation is preferably performed by a method such as atmospheric distillation or distillation under reduced pressure. In addition, in a case of adding a stabilizing agent such as acetyl acetone, it is preferable that the stabilizing agent be added simultaneously with the injection of the PNbZT precursor to be circulated under the above-described conditions.

After the circulation, the synthesized liquid is left at room temperature to be cooled to a temperature of room temperature to 40°C. Thereafter, another solvent such as butanol is added and stirred to dilute the synthesized liquid so that the ratio of the PNbZT precursor to the 100 mass% of the sol-gel solution after the production is adjusted to 5 mass% to 30 mass%, and preferably 10 mass% to 25 mass% in terms of the amount of oxide.

In addition, after the preparation of the sol-gel solution, it is preferable that particles be removed by a filtration process or the like so that the number of particles having a particle size of 0.5 µm or more (particularly, 0.3 µm or more, and particularly 0.2 µm or more) is equal to or lower than 50 per 1 milliliter of the sol-gel solution. When the number of particles having a particle size of 0.5 µm or more in the sol-gel solution exceeds 50 per 1 milliliter, long-term storage stability is deteriorated. The smaller the number of particles having a particle size of 0.5 µm or more in the sol-gel solution, the more preferable it is. Particularly, it is preferable that the number of particles be 30 or less per 1 milliliter.

A method of treating the sol-gel solution after the preparation to achieve the above-mentioned number of particles is not particularly limited, and for example, the following method may be employed. A first method is a filtration method in which the sol-gel solution is forcibly fed by a syringe using a commercially available membrane filter having a hole diameter of 0.2 µm. A second method is a pressure filtration method in which a commercially available membrane filter having a hole diameter of 0.05 µm and a pressure tank are combined. A third method is a circulation filtration method in which the filter used in the second method and a solution circulating tank are combined.

In any method, the particle capturing rates of the filters vary depending on the force-feeding pressure of the sol-gel solution. It is generally known that the capturing rate is increased as pressure is decreased. Particularly, in the first method and the second method, in order to realize the conditions in which the number of particles having a particle size of 0.5 µm or more is equal to or less than 50 per 1 milliliter, it is preferable that the sol-gel solution flow through the filter very slowly at a low pressure. Examples of the sol-gel solution which is appropriate for the formation of the PNbZT thin film of the present invention and is commercially available include an E1 solution produced by Mitsubishi Materials Corporation.

The PNbZT thin film obtained according to the method of the present invention has extremely appropriate piezoelectric characteristics and permittivity, and thus can be appropriately used as a constituent material when manufacturing electronic components of a thin-film condenser, a thin film capacitor, an IPD, a condenser for a DRAM memory, a multi-layer condenser, the gate insulator of a transistor, a non-volatile memory, a pyroelectric infrared detecting element, a piezoelectric element, an electro-optic element, a thin film actuator, a resonator, an ultrasonic motor, an electric switch, an optical switch, or an LC noise filter element.

### EXAMPLES

Next, Examples of the present invention and Comparative Examples will be described in detail.

### <Comparative Example 1>

As a sol-gel solution for forming a PNbZT thin film, a sol-gel solution (an E1 solution manufactured by Mitsubishi Materials Corporation) in which the metal composition ratio was 125/10/52/48 (Pb/Nb/Zr/Ti) and the concentration (the sum of a Pb source, an Nb source, a Zr source, and a Ti source) of a precursor diluted using 1-butanol as a solvent was adjusted to 15 mass% in terms of oxide amount was prepared. Here, the reason that the ratio of Nb was set to be significantly higher than the upper limit of Nb expressed in the composition formula Pb_{z}NbₓZr_{y}Ti_{1-y}O₃ (0<x≤0.05, 4.40≤y≤0.60, and 1,05≤z≤1.25) is to easily examine the presence or absence of segregation of Nb, Zr, and Ti. In addition, a substrate was prepared in which an SiO₂ film was formed on a silicon substrate body having a diameter of 100 mm, a lower electrode including a TiOₓ film and a Pt film was formed on the SiO₂ film, and a crystallization acceleration layer was formed on the Pt film.

In addition, in Comparative Example 1 and in Examples 1 to 7 and Comparative Examples 2 to 6 described below, unless otherwise specified, a (100)-textured PZT thin film was formed on a Pt film as the crystallization acceleration layer and thereafter a PNbZT film was formed on the crystallization acceleration layer. In addition, as a composition for forming a PZT ferroelectric thin film to form the crystallization acceleration layer, a PZT sol-gel solution (trade name: PZT-E1 manufactured by Mitsubishi Materials Corporation) in which the metal composition ratio was 115/53/47 (Pb/Zr/Ti) and the concentration (the sum of a Pb source, a Zr source, and a Ti source) of a precursor diluted using 1-butanol as a solvent was adjusted to 12 mass% in terms of oxide amount was prepared. First, the prepared PZT sol-gel solution was dropped onto the Pt (lower electrode) of the Pt/TiOₓ/SiO₂/Si substrate in which the crystal plane is preferentially textured in the (111) axis direction, and the resultant was subjected to spin coating at a rotational speed of 3000 rpm for 15 seconds, thereby forming a coating film (gel film) on the substrate. Thereafter, the coating film formed on the substrate was calcined by being held at a temperature of 300°C in an air atmosphere for 5 minutes using a hot plate. In addition, the processes from the application of the composition to the calcination were repeated three times. Thereafter, baking was performed by increasing the temperature from room temperature to 700°C at a temperature rising rate of 10°C/s in an oxygen atmosphere through a rapid thermal annealing (RTA) process and holding the temperature for 1 minute. Accordingly, the crystallization acceleration layer formed of the PZT dielectric thin film having a film thickness of 60 nm and (100)-textured crystal orientation was formed.

Next, the substrate was set on a spin coater so that the crystallization acceleration layer was positioned at the upper surface, and while rotating the substrate at a rotational speed of 3000 rpm, the sol-gel solution was dropped onto the crystallization acceleration layer of the substrate for 15 seconds, thereby forming a coating film (gel film) on the crystallization acceleration layer of the substrate. Next, the substrate on which the coating film was formed was calcined by being held at a temperature of 300°C for 5 minutes on the hot plate and was thereafter calcined by being held at a temperature of 450°C for 5 minutes, thereby calcining the coating film. By repeating the processes from the application of the sol-gel solution to the calcination three times, three layers of calcined films were formed on the crystallization acceleration layer of the substrate. Furthermore, the substrate on which the calcined films were formed was baked by being held at 700°C for 1 minute in the oxygen atmosphere through the rapid thermal annealing (RTA) process. The temperature rising rate at this time was 10 °C/s. Accordingly, a single PNbZT thin film having a thickness of 240 nm was formed on the Pr film of the substrate. The process of forming the PNbZT thin film, in which the processes from the application of the sol-gel solution to the calcination were repeated three times and the baking was thereafter performed once, was repeated four times, thereby forming a PNbZT thin film having four layers with a total thickness of about 1 µm on the crystallization acceleration layer of the substrate. The substrate on which the PNbZT thin film was formed was used in Comparative Example 1.

### <Test 1 and Evaluation>

The PNbZT thin film formed on the substrate of Comparative Example 1 was subjected to composition analysis by an energy-dispersive X-ray spectrometer (TEM-EDS) which uses a transmission electron microscope. Specifically, the PNbZT thin film was processed to a thickness of 50 nm by a focused ion beam (FIB), and thereafter the PNbZT thin film having a thickness of 50 nm was subjected to composition analysis for each component in a sectional direction of the PNbZT thin film by the TEM-EDS apparatus.

As a result, the concentration of Zr in the PNbZT thin film was high in the film upper portion (the opposite side of the crystallization acceleration layer) and was gradually decreased toward the film lower portion (the side coming into contact with the crystallization acceleration layer). In addition, contrary to the concentration of Zr, the concentration of Ti in the PNbZT thin film was low in the film upper portion (the opposite side of the crystallization acceleration layer) and was gradually increased toward the film lower portion (the side coming into contact with the crystallization acceleration layer). On the other hand, the concentration of Nb in the PNbZT thin film is substantially uniform at any point in the film and segregation thereof was not seen. The above description implies that in a CSD method, in order to form a PNbZT thin film (a PZT film containing Nb added thereto) having high characteristics, it is important to eliminate composition unevenness after baking by laminating coating films (gel films) with composition ratios of Zr and Ti, which are changed in a stepwise manner, during film formation and thereafter baking the resultant.

### <Example 1>

As a sol-gel solution for forming a PNbZT thin film, a first sol-gel solution (an E1 solution manufactured by Mitsubishi Materials Corporation) in which the metal composition ratio was 116/1/60/40 (Pb/Nb/Zr/Ti) and the concentration (the sum of a Pb source, an Nb source, a Zr source, and a Ti source) of a precursor diluted using 1-butanol as a solvent was adjusted to 10 mass% in terms of oxide amount was prepared. In a similar manner, a second sol-gel solution in which the metal composition ratio was 116/1/54/46 (Pb/Nb/Zr/Ti), a third sol-gel solution in which the metal composition ratio was 116/1/52/48 (Pb/Nb/Zr/Ti), a fourth sol-gel solution in which the metal composition ratio was 116/1/50/50 (Pb/Nb/Zr/Ti), and a fifth sol-gel solution in which the metal composition ratio was 116/1/44/56 (Pb/Nb/Zr/Ti) were prepared. Furthermore, the same substrate as in Comparative Example 1 was prepared. In addition, the first to fifth sol-gel solutions were prepared using the E1 solution manufactured by Mitsubishi Materials Corporation.

First, the substrate was set on a spin coater so that the crystallization acceleration layer was positioned at the upper surface, and while rotating the substrate at a rotational speed of 3000 rpm, the first sol-gel solution was dropped onto the crystallization acceleration layer of the substrate for 15 seconds, thereby forming a coating film (gel film) on the crystallization acceleration layer of the substrate. The substrate on which the coating film was formed was calcined by being held at a temperature of 300°C for 5 minutes on a hot plate and was thereafter calcined by being held at a temperature of 450°C for 5 minutes, thereby calcining the coating film and forming a first calcined film. Next, by changing the first sol-gel solution to the second sol-gel solution, in the same manner, a second calcined film was formed on the first calcined film by performing the application of the second sol-gel solution and calcination in two stages. In addition, by changing the second sol-gel solution to the third sol-gel solution, in the same manner, a third calcined film was formed on the second calcined film by performing the application of the third sol-gel solution and calcination in two stages. Next, by changing the third sol-gel solution to the fourth sol-gel solution, in the same manner, a fourth calcined film was formed on the third calcined film by performing the application of the fourth sol-gel solution and calcination in two stages. In addition, by changing the fourth sol-gel solution to the fifth sol-gel solution, in the same manner, a fifth calcined film was formed on the fourth calcined film by performing the application of the fifth sol-gel solution and calcination in two stages. As described above, five layers including the first to fifth calcined films each of which has a thickness of 50 nm were formed on the crystallization acceleration layer of the substrate. Furthermore, the substrate on which the first to fifth calcined films were formed was baked under the same conditions as those of Comparative Example 1. Accordingly, a single PNbZT thin film having a thickness of 250 nm was formed on the crystallization acceleration layer of the substrate. The process of forming the PNbZT thin film, in which the processes from the application of the first to fifth sol-gel solutions to the calcination were repeated five times and the baking was thereafter performed once, was repeated four times, thereby forming a PNbZT thin film having four layers with a total thickness of about 1 µm (about 1000 nm) on the crystallization acceleration layer of the substrate. The substrate on which the PNbZT thin film was formed was used in Example 1.

### <Example 2>

A PNbZT thin film was formed on the crystallization acceleration layer of the substrate in the same manner as in Example 1 except that, by repeating the process of forming the PNbZT thin film eight times, in which the processes from the application of the first to fifth sol-gel solutions to the calcination were repeated five times and the baking was performed once, the PNbZT thin film having eight layers with a total thickness of about 2 µm (about 2000 nm) was formed on the crystallization acceleration layer of the substrate. The substrate on which the PNbZT thin film was formed was used in Example 2.

### <Examples 3, 4, and 7>

A PNbZT thin film was formed in the same manner as in Example 1 except that the concentrations of the sol-gel solutions, the number of times of application of the coating films for each baking process, the film thickness of one layer, the film thicknesses after the baking, the concentration ratio of Pt/Nb, the concentration ratio Zr/Ti for each coating film, the number of times of baking processes of the PNbZT thin film, and the film thickness of the PNbZT thin film (hereinafter, referred to as various conditions) were changed as shown in Tables 1 and 2.

The substrate on which the PNbZT thin film was formed was used in Examples 3, 4, and 7.

In addition, in Examples 3, 4, and 7, only three types including the first to third sol-gel solutions were prepared, the first to third coating films were formed using the respective sol-gel solutions, and thereafter the resultant was baked. This point is the same in the following examples, and a plurality of sol-gel solutions shown in Tables 1 and 2 were used, and coating films corresponding thereto were formed.

### <Examples 5 and 6>

A PNbZT thin film was formed in the same manner as in Example 1 except that the various conditions were changed as shown in Tables 1 and 2. The substrate on which the PNbZT thin film was formed was used in Examples 5 and 6.

In addition, in Examples 5 and 6, the first and second sol-gel solutions were synthesized by the following method. Lead acetate trihydrate, titanium tetraisopropoxide, zirconium (iv) tetrabutoxide, niobium pentaethoxide, acetyl acetone, and propylene glycol were weighed so as to allow the metal composition ratio Pb/Nb/Zr/Ti to achieve the above-mentioned ratio, and were then injected into a reaction container and circulated while being held at 150°C for 1 hour in a nitrogen atmosphere. The circulated mixed liquid was subjected to distillation under reduced pressure to remove unreacted substances from the mixed liquid. In addition, after the inside of the reaction container was cooled to room temperature, water was added thereto and the resultant was circulated while being held at 150°C for 1 hour in the nitrogen atmosphere, and the inside of the reaction container was cooled to room temperature again. Thereafter, 2.5 mol% of polyvinylpyrrolidone (PVP) was added to PZT in terms of monomer amount, and the resultant was stirred at room temperature for 24 hours. The stirred mixed liquid was diluted with ethanol, thereby obtaining 25 mass% of the first and second sol-gel solutions (PNbZT solutions) in terms of the amount of oxides.

### <Comparative Examples 2, 3, 5, and 6>

A PNbZT thin film was formed in the same manner as in Example 1 except that the various conditions were changed as shown in Tables 1 and 2. The substrate on which the PNbZT thin film was formed was used in Comparative Examples 2, 3, 5, and 6.

A single sol-gel solution was used in Comparative Examples 2 and 3, first to fifth coating films were formed in Comparative Example 2, and first to third coating films were formed in Comparative Example 3.

The Nb content of a sol-gel solution of Comparative Example 5 was high, and a sol-gel solution of Comparative Example 6 did not contain Nb.

### <Comparative Example 4>

A PNbZT thin film was formed in the same manner as in Example 5 except that the various conditions were changed as shown in Tables 1 and 2. The substrate on which the PNbZT thin film was formed was used in Comparative Example 4.

In Comparative Example 4, a single sol-gel solution was used, and first and second coating films were formed.

### <Test 2 and Evaluation>

The PNbZT thin film formed on the substrate of Examples 1 to 7 and Comparative Examples 2 to 6 were subjected to composition analysis, permittivity measurement, and piezoelectric constant measurement. The composition analysis of the PNbZT thin film was performed by the energy-dispersive X-ray spectrometer (TEM-EDS) which uses a transmission electron microscope. Specifically, first, the PNbZT thin film was processed to one layer of the PNbZT thin film obtained in a single baking process by a focused ion beam (FIB). That is, one layer of the PNbZT thin film was produced by being processed to a thickness of 50 nm in Examples 1 and 2 and Comparative Example 2, one layer of the PNbZT thin film was produced by being processed to a thickness of 84 nm in Examples 3 and 4 and Comparative Examples 3, 5, and 6, and one layer of the PNbZT thin film was produced by being processed to a thickness of 200 nm in Examples 5 and 6 and Comparative Example 4. Next, the PNbZT thin films were subjected to composition analysis for each component in a sectional direction of the PNbZT thin film by the TEM-EDS apparatus, and a percentage of a value which the difference between the amount of Zr in the vicinity of the uppermost portion and the amount of Zr in the vicinity of the lowermost portion of the PNbZT thin film obtained in a single baking process was divided by the amount of Zr in the vicinity of the lowermost portion was calculated as a variation of Zr in the film thickness direction.

The permittivity measurement was performed using a ferroelectric evaluation apparatus (TF-analyzer2000 manufactured by aixACCT Systems). Specifically, an electrode of 200 µmφ was formed on each of both surfaces of the PNbZT thin film by a sputtering method, and the resultant was thereafter held at 700°C for 1 minute in an oxygen atmosphere through a rapid thermal annealing (RTA) process, and was subjected to annealing to recover damage, thereby producing a thin-film condenser. The permittivity of the thin-film condenser as a test sample was measured by the ferroelectric evaluation apparatus. To obtain a non-dimensional value, the measured permittivity was divided by the permittivity in a vacuum, thereby calculating a relative permittivity. The relative permittivity is a value including the crystallization acceleration layer in addition to the PNbZT thin film.

The piezoelectric constant measurement was performed using a piezoelectric evaluation apparatus (aixPES manufactured by aixACCT Systems). Specifically, first, the PNbZT thin film was processed to a strip shape by a focused ion beam (FIB). Thereafter the PNbZT thin film formed in the strip shape was subjected to a polarization process of holding at a temperature of 110°C for 1 minute in an electric field of 100 kV/cm. Furthermore, strain was applied to the PNbZT thin film subjected to the polarization process, and a charge amount generated was measured by the piezoelectric evaluation apparatus, thereby obtaining the piezoelectric constant e_{31,f}. The results are shown in Table 2. In Table 2, the concentrations of the sol-gel solutions, the number of times of application of the coating films for each baking process, the film thickness of one layer, the film thicknesses after the baking, the presence or absence of concentration gradients of Zr/Ti, the number of times of baking processes of the PNbZT thin film, and the film thickness of the PNbZT thin film are also shown. In addition, in Table 1, in addition to the concentrations of the sol-gel solutions, the number of times of application of the coating films after the baking, the film thickness of one layer, the film thicknesses after the baking, and the concentration ratio Pb/Nb, the concentration ratio Zr/Ti for each coating film is shown.

**[Table 1]**

| | Concentration of sol-gel solution (%) | Coating film (for each baking) | | | | | | | | |
|---|---|---|---|---|---|---|---|---|---|---|
| | | Number of times of application (times) | Film thickness | | Concentration ratio Pb/Nb | Concentration ratio Zr/Ti | | | | |
| | | | One layer [nm] | After baking (nm) | | First coating film | Second coating film | Third coating film | Fourth coating film | Fifth coating film |
| Example 1 | 10 | 5 | 50 | 250 | 116/1 | 60/40 | 54/46 | 52/48 | 50/50 | 44/56 |
| Example 2 | 10 | 5 | 50 | 250 | 116/1 | 60/40 | 54/46 | 52/48 | 50/50 | 44/56 |
| Example 3 | 15 | 3 | 84 | 250 | 120/5 | 60/40 | 52/48 | 44/56 | - | - |
| Example 4 | 15 | 3 | 84 | 250 | 120/5 | 60/40 | 52/48 | 44/56 | - | - |
| Example 5 | 25 | 2 | 200 | 400 | 116/1 | 54/46 | 50/50 | - | - | - |
| Example 6 | 25 | 2 | 200 | 400 | 116/1 | 54/46 | 50/50 | - | - | - |
| Example 7 | 15 | 3 | 84 | 250 | 120/5 | 60/40 | 52/48 | 44/56 | - | - |
| Comparative Example 2 | 10 | 5 | 50 | 250 | 116/1 | 52/48 | 52/48 | 52/48 | 52/48 | 52/48 |
| Comparative Example 3 | 15 | 3 | 84 | 250 | 116/1 | 52/48 | 52/48 | 52/48 | - | - |
| Comparative Example 4 | 25 | 2 | 200 | 400 | 116/1 | 52/48 | 52/48 | - | - | - |
| Comparative Example 5 | 15 | 3 | 84 | 250 | 121/6 | 60/40 | 52/48 | 44/56 | - | - |
| Comparative Example 6 | 15 | 3 | 84 | 250 | 115/0 | 60/40 | 52/48 | 44/56 | - | - |

**[Table 2]**

| | Concentration of sol-gel solution (%) | Coating film (for each baking) | | | | PNbZT thin film | | | | |
|---|---|---|---|---|---|---|---|---|---|---|
| | | Number of times of application (times) | Film thickness | | Presence or absence of concentration gradient of Zr/Ti for each coating film | Number of times of baking (times) | Film thickness (nm) | Variation of Zr in film thickness direction (%) | Relative permittivity | Piezoelectric constant e_{31,f} (C/m²) |
| | | | One layer [nm] | After baking (nm) | | | | | | |
| Example 1 | 10 | 5 | 50 | 250 | Present | 4 | 1000 | 1.2 | 1980 | -19.3 |
| Example 2 | 10 | 5 | 50 | 250 | Present | 8 | 2000 | 1.1 | 2010 | -20.1 |
| Example 3 | 15 | 3 | 84 | 250 | Present | 4 | 1000 | 2.3 | 2300 | -18.4 |
| Example 4 | 15 | 3 | 84 | 250 | Present | 12 | 3000 | 2.2 | 1950 | -19.1 |
| Example 5 | 25 | 2 | 200 | 400 | Present | 5 | 2000 | 2.8 | 1810 | -17.5 |
| Example 6 | 25 | 2 | 200 | 400 | Present | 12 | 4800 | 2.8 | 1680 | -16.8 |
| Example 7 | 15 | 3 | 84 | 250 | Present | 4 | 1000 | 2.0 | 1930 | -18.9 |
| Comparative Example 2 | 10 | 5 | 50 | 250 | Absent | 4 | 1000 | 6.2 | 1420 | -13.2 |
| Comparative Example 3 | 15 | 3 | 84 | 250 | Absent | 4 | 1000 | 5.6 | 1500 | -14.1 |
| Comparative Example 4 | 25 | 2 | 200 | 400 | Absent | 5 | 2000 | 8.3 | 1340 | -12.6 |
| Comparative Example 5 | 15 | 3 | 84 | 250 | Present | 4 | 1000 | 7.4 | 1930 | -13.4 |
| Comparative Example 6 | 15 | 3 | 84 | 250 | Present | 4 | 1000 | 6.4 | 1500 | -15.0 |

As is apparent from Table 2, in Comparative Examples 2 to 4 in which coating films including two layers, three layers, or five layers having the same concentration ratio Zr/Ti were laminated on the crystallization acceleration layer of the substrate, the variation of Zr in the film thickness direction in one layer of the PNbZT thin film was as high as 5.6% to 8.3%. In contrast, in Examples 1 to 6 in which the coating films including two layers, three layers, or five layers were laminated on the crystallization acceleration layer of the substrate to allow the concentration ratio Zr/Ti to be decreased in a stepwise manner, the variation of Zr in the film thickness direction in one layer of the PNbZT thin film was as low as 1.1% to 2.8%. That is, in Examples 1 to 6, each composition in the PNbZT thin film is substantially uniform.

In addition, in Comparative Examples 2 to 4, the relative permittivity of the thin-film condenser was as low as 1340 to 1500. In contrast, in Examples 1 to 6, the relative permittivity of the thin-film condenser was as high as 1680 to 2300.

Furthermore, in Comparative Examples 2 to 4, the absolute value of the piezoelectric constant of the PNbZT thin film was as low as 12.6 C/m² to 14.1 C/m². In contrast, in Examples 1 to 6, the absolute value of the piezoelectric constant of the PNbZT thin film was as high as 16.8 C/m² to 20.1 C/m². Accordingly, in Examples 1 to 6, it was found that dielectric characteristics were enhanced.

On the other hand, in Comparative Example 5 in which the coating films including three layers were laminated using the first to third sol-gel solutions having a concentration ratio of Pb/Nb of 121/6 and thus having a high Nb content, the variation of Zr in the film thickness direction in one layer of the PNbZT thin film was as high as 7.4. In Comparative Example 6 in which the coating films including three layers were laminated using the first to third sol-gel solutions having a concentration ratio of Pb/Nb of 115/0 and thus not containing Nb at all, the variation of Zr in the film thickness direction in one layer of the PNbZT thin film was as high as 6.4. In contrast, in Examples 3 and 7 in which the coating films including three layers were laminated using the first to third sol-gel solutions having concentration ratio Pb/Nb of 120/5 and 116/1 and thus having appropriate Nb contents, the variation of Zr in the film thickness direction in one layer of the PNbZT thin film was as low as 2.3 and 2.0. Accordingly, it was found that in Examples 3 and 7 in which Nb was contained in appropriate proportions, each composition in the PNbZT thin film is substantially uniform.

In addition, in Comparative Example 6, the relative permittivity of the thin-film condenser was as low as 1500. In contrast, in Comparative Example 5, the relative permittivity of the thin-film condenser was as high as 1930, and in Examples 3 and 7, the relative permittivity of the thin-film condenser was as high as 2300 and 1930. Accordingly, it was found that in Examples 3 and 7 in which Nb was contained in appropriate proportions and in Comparative Example 5 in which Nb was contained in a high proportion, dielectric characteristics were enhanced.

Moreover, in Comparative Example 5, the absolute value of the piezoelectric constant of the PNbZT thin film was as low as 13.4, and in Comparative Example 6, the absolute value of the piezoelectric constant of the PNbZT thin film was as low as 15.0. In contrast, in Examples 3 and 7, the absolute value of the piezoelectric constant of the PNbZT thin film was as high as 18.4 and 18.9. Accordingly, it was found that in Examples 3 and 7 in which Nb was contained in appropriate proportions, piezoelectric characteristics were enhanced.

### INDUSTRIAL APPLICABILITY

The method for manufacturing a PNbZT thin film of the present invention can be used for manufacturing of electronic components of a thin-film condenser, a thin film capacitor, an IPD, a condenser for a DRAM memory, a multi-layer condenser, the gate insulator of a transistor, a non-volatile memory, a pyroelectric infrared detecting element, a piezoelectric element, an electro-optic element, a thin film actuator, a resonator, an ultrasonic motor, an electric switch, an optical switch, or an LC noise filter element.

### REFERENCE SIGNS LIST

- 11: PNbZT thin film
- 11a: first calcined film
- 11b: second calcined film
- 11c: third calcined film
- 12: substrate

## Claims

1. A method for manufacturing a PNbZT thin film includes:
a process of preparing a plurality of types of sol-gel solutions having different concentration ratio of zirconium and titanium (Zr/Ti) while satisfying the composition formula Pb_{z}NbₓZr_{y}Ti_{1-y}O₃ (0<x≤0.05, 0.40≤y≤0.60, and 1.05≤z≤1.25);
a process of laminating at least two layers of calcined films, in which the concentration ratio Zr/Ti are decreased in a stepwise manner, on a substrate by selecting a predetermined sol-gel solution from among the plurality of types of sol-gel solutions so as to allow the concentration ratio Zr/Ti to be decreased in a stepwise manner, and repeating application of the sol-gel solutions onto the substrate and calcining the resultant at least two times; and
a process of obtaining a single PNbZT thin film formed from lead niobate zirconium titanate-based complex perovskite by simultaneously baking a plurality of the calcined films,
wherein a composition variation of zirconium in a film thickness direction of the single PNbZT thin film after the baking is 5% or lower.

2. The method for manufacturing a PNbZT thin film according to claim 1,
wherein a thickness of the single PNbZT thin film is 250 nm to 400 nm.

3. The method for manufacturing a PNbZT thin film according to claim 1 or 2,
wherein the substrate includes a substrate body, an SiO₂ film provided on the substrate body, a lower electrode provided on the SiO₂ film, and a crystallization acceleration layer provided on the lower electrode,
the lower electrode has a TiOₓ film and a Pt film in this order from the substrate body,
the crystallization acceleration layer is a ferroelectric thin film formed of a complex perovskite film made of lead zirconate titanate provided on the Pt film, and
in the process of laminating at least two layers of calcined films, at least two layers of calcined films are formed on the crystallization acceleration layer.

4. A method for manufacturing an electronic component of a thin-film condenser, a thin film capacitor, an IPD, a condenser for a DRAM memory, a multi-layer condenser, the gate insulator of a transistor, a non-volatile memory, a pyroelectric infrared detecting element, a piezoelectric element, an electro-optic element, a thin film actuator, a resonator, an ultrasonic motor, an electric switch, an optical switch, or an LC noise filter element, which has the PNbZT thin film according to the method according to any one of claims 1 to 3.

## Patentansprüche

1. Ein Verfahren zur Herstellung einer PNbZT-Dünnschicht, die beinhaltet:
Ein Verfahren zur Herstellung einer Mehrzahl von Arten von Sol-Gel-Lösungen, die ein unterschiedliches Konzentrationsverhältnis von Zirkonium und Titan (Zr/Ti) aufweisen, während sie der Zusammensetzungsformel Pb_{z}NbₓZr_{y}Ti_{1-y}O₃ (0<x≤0,05, 0,40≤y≤0,60, und 1,05≤z≤1,25) genügen;
ein Verfahren der Beschichtung eines Substrates mit mindestens zwei Lagen kalzinierter Schichten, bei dem das Konzentrationsverhältnis von Zr/Ti auf schrittweise Art verringert wird, durch die Auswahl einer vorbestimmten Sol-Gel-Lösung aus der Mehrzahl von Arten von Sol-Gel-Lösungen, um das Verringern des Konzentrationsverhältnisses Zr/Ti in einer schrittweisen Art zu ermöglichen, und das Wiederholen des Auftragens der Sol-Gel-Lösungen auf das Substrat und das Kalzinieren des daraus Resultierenden, das mindestens zweimal durchgeführt wird; und
ein Verfahren, bei dem eine einzelne aus einem Bleiniobatzirkoniumtitanat-basierten komplexen Perovskit gebildete PNbZT-Dünnschicht durch gleichzeitiges Brennen einer Mehrzahl der kalzinierten Schichten gebildet wird,
wobei die Zusammensetzungsvariation von Zirkonium in Richtung der Schichtdicke der einzelnen PNbZT-Dünnschicht nach dem Brennen 5% oder weniger beträgt.

2. Das Verfahren zur Herstellung einer PNbZT-Dünnschicht gemäß Anspruch 1,
wobei die Dicke der einzelnen PNbZT-Dünnschicht 250 nm bis 400 nm beträgt.

3. Das Verfahren zur Herstellung einer PNbZT-Dünnschicht gemäß Anspruch 1 oder 2,
wobei das Substrat einen Substratkörper, eine auf dem Substratkörper bereitgestellte SiO₂-Schicht, eine auf der SiO₂-Schicht bereitgestellte untere Elektrode, und eine auf der unteren Elektrode bereitgestellte Kristallisationsbeschleunigungsschicht beinhaltet,
die untere Elektrode eine TiOₓ-Schicht und eine Pt-Schicht in dieser Reihenfolge ausgehend vom Substratkörper aufweist,
die Kristallisationsbeschleunigungsschicht eine auf der Pt-Schicht bereitgestellte,
von einer komplexen Perovskit-Schicht gebildete ferroelektrischen Dünnschicht, die aus Bleizirkonattitanat hergestellt ist, ist,
im Verfahren der Beschichtung mit mindestens zwei Lagen kalzinierter Schichten mindestens zwei Schichten der kalzinierten Schichten auf der Kristallisationsbeschleunigungsschicht gebildet werden.

4. Ein Verfahren zur Herstellung einer elektronischen Komponente eines Dünnschichtkondensators, eines integrierten passiven Bauelements (IPD), eines Kondensators für einen DRAM-Speicher, eines Mehrschichtkondensators, eines Gate-Isolators eines Transistors, eines Festspeichers, eines pyroelektrischen Infrarotdetektierenden Elements, eines piezoelektrischen Elements, eines elektro-optischen Elements, eines Dünnschichtaktuators, eines Resonators, eines Ultraschallmotors, eines elektrischen Schalters, eines optischen Schalters, oder eines LC-Rauschfilterelements, welches über die PNbZT-Dünnschicht gemäß dem Verfahren gemäß einem der Ansprüche 1 bis 3 verfügt.

## Revendications

1. Procédé de fabrication d'un film mince PNbZT comportant :
un procédé de préparation d'une pluralité de types de solutions sol-gel ayant différents rapports de concentration de zirconium et titane (Zr/Ti) tout en satisfaisant la formule de composition Pb_{z}NbₓZr_{y}Ti_{1-y}O₃ (0 < x ≤ 0,05 ; 0,40 ≤ y ≤ 0,60 ; et 1,05 ≤ z ≤ 1,25) ;
un procédé de stratification d'au moins deux couches de films calcinés, où les rapports de concentration Zr/Ti diminuent de manière progressive, sur un substrat en sélectionnant une solution sol-gel prédéterminée parmi la pluralité de types de solutions sol-gel de manière à permettre au rapport de concentration Zr/Ti de diminuer de manière progressive, et en répétant l'application des solutions sol-gel sur le substrat et en calcinant le produit résultant au moins deux fois ; et
un procédé d'obtention d'un film mince PNbZT unique formé à partir de pérovskite complexe à base de titanate de zirconium et de niobate de plomb par cuisson simultanée d'une pluralité de films calcinés,
dans lequel une variation de composition de zirconium dans une direction d'épaisseur de film du film mince de PNbZT unique après cuisson est inférieure ou égale à 5%.

2. Procédé de fabrication d'un film mince PNbZT selon la revendication 1,
dans lequel l'épaisseur du film mince de PNbZT unique est comprise entre 250 nm et 400 nm.

3. Procédé de fabrication d'un film mince PNbZT selon la revendication 1 ou 2,
dans lequel le substrat comporte un corps de substrat, un film de SiO₂ prévu sur le corps de substrat, une électrode inférieure prévue sur le film de SiO₂ et une couche d'accélération de cristallisation prévue sur l'électrode inférieure,
l'électrode inférieure ayant un film de TiOₓ et un film de Pt dans cet ordre à partir du corps de substrat,
la couche d'accélération de cristallisation étant un film mince ferroélectrique formé d'un film de pérovskite complexe réalisé en titano-zirconate de plomb prévu sur le film de Pt, et
dans le procédé de stratification d'au moins deux couches de films calcinés, au moins deux couches de films calcinés sont formées sur la couche d'accélération de cristallisation.

4. Procédé de fabrication d'un composant électronique d'un condensateur à film mince, d'une capacité à couche mince, d'un IPD, d'un condensateur pour une mémoire DRAM, d'un condensateur multicouche, de l'isolant de grille d'un transistor, d'une mémoire non volatile, d'un élément de détection à infrarouge pyroélectrique, d'un élément piézoélectrique, d'un élément électro-optique, d'un actionneur à film mince, d'un résonateur, d'un moteur à ultrasons, d'un commutateur électrique, d'un commutateur optique ou d'un élément de filtre de bruit LC, qui a le film mince PNbZT obtenu selon le procédé selon l'une quelconque des revendications 1 à 3.
